(19) Europäisches Patentamt
European Patent Office
Office européen des brevets

(11) Publication number: **0 483 876 B1**

(12) **EUROPEAN PATENT SPECIFICATION**

(45) Date of publication of patent specification: **28.09.94**

(51) Int. Cl.5: **B41M 5/38**, G03F 3/10

(21) Application number: **91118665.8**

(22) Date of filing: **31.10.91**

# (54) Mixture of dyes for black dye donor for thermal color proofing.

(30) Priority: **02.11.90 US 608507**
**28.03.91 US 677000**

(43) Date of publication of application:
**06.05.92 Bulletin 92/19**

(45) Publication of the grant of the patent:
**28.09.94 Bulletin 94/39**

(84) Designated Contracting States:
**DE FR GB**

(56) References cited:
**EP-A- 0 216 483**
**EP-A- 0 270 677**
**US-A- 4 816 435**

(73) Proprietor: **EASTMAN KODAK COMPANY**
**343 State Street**
**Rochester New York 14650-2201 (US)**

(72) Inventor: **Chapman, Derek David, c/o EASTMAN KODAK COMPANY**
**Patent Department,**
**343 State Street**
**Rochester, New York 14650-2201 (US)**
Inventor: **Evans, Steven, c/o EASTMAN KODAK COMPANY**
**Patent Department,**
**343 State Street**
**Rochester, New York 14650-2201 (US)**

(74) Representative: **Brandes, Jürgen, Dr. rer. nat. et al**
**Wuesthoff & Wuesthoff**
**Patent- und Rechtsanwälte**
**Schweigerstrasse 2**
**D-81541 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

This invention relates to use of a mixture of cyan, yellow and magenta dyes in a black dye-donor element for thermal dye transfer imaging which can be used in a four-color proofing system that accurately represents the hue of a printed color image obtained from a printing press.

In order to approximate the appearance of continuous-tone (photographic) images via ink-on-paper printing, the commercial printing industry relies on a process known as halftone printing. In halftone printing, color density gradations are produced by printing patterns of dots or areas of varying sizes, but of the same color density, instead of varying the color density continuously as is done in photographic printing.

There is an important commercial need to obtain a color proof image before a printing press run is made. It is desired that the color proof will accurately represent at least the details and color tone scale of the prints obtained on the printing press. In many cases, it is also desirable that the color proof accurately represent the image quality and halftone pattern of the prints obtained on the printing press. In the sequence of operations necessary to produce an ink-printed, full-color picture, a proof is also required to check the accuracy of the color separation data from which the final three or more printing plates or cylinders are made. Traditionally, such color separation proofs have involved silver halide photographic, high-contrast lithographic systems or non-silver halide light-sensitive systems which require many exposure and processing steps before a final, full-color picture is assembled.

Colorants that are used in the printing industry are insoluble pigments. In particular, carbon is often used in such a black ink and results in fairly uniform absorbance across the visible spectrum. In thermal transfer color printing systems that use diffusible dyes it is often difficult to find a blend of two or more dyes which yields both uniform neutral (black) color and fulfills the other requirements of the printing system such as transfer efficiency and donor storage stability.

In EP-A-0 454 083 (state of the art according to Article 54(3) EPC), a process is described for producing a direct digital, halftone color proof of an original image on a dye-receiving element. The proof can then be used to represent a printed color image obtained from a printing press. The process described therein comprises:

a) generating a set of electrical signals which is representative of the shape and color scale of an original image;

b) contacting a dye-donor element comprising a support having thereon a dye layer and an infrared-absorbing material with a first dye-receiving element comprising a support having thereon a polymeric, dye image-receiving layer;

c) using the signals to imagewise-heat by means of a diode laser the dye-donor element, thereby transferring a dye image to the first dye-receiving element; and

d) retransferring the dye image to a second dye image-receiving element which has the same substrate as the printed color image.

In the above process, multiple dye-donors are used to obtain a complete range of colors in the proof. For example, for a full-color proof, four colors: cyan, magenta, yellow and black are normally used.

By using the above process, the image dye is transferred by heating the dye-donor containing the infrared-absorbing material with the diode laser to volatilize the dye, the diode laser beam being modulated by the set of signals which is representative of the shape and color of the original image, so that the dye is heated to cause volatilization only in those areas in which its presence is required on the dye-receiving layer to reconstruct the original image.

Similarly, a thermal transfer proof can be generated by using a thermal head in place of a diode laser as described in U.S. Patent 4,923,846. Commonly available thermal heads are not capable of generating halftone images of adequate resolution but can produce high quality continuous tone proof images which are satisfactory in many instances. U.S. Patent 4,923,846 also discloses the choice of mixtures of dyes for use in thermal imaging proofing systems. The dyes are selected on the basis of values for hue error and turbidity. The Graphic Arts Technical Foundation Research Report No. 38, "Color Material" (58-(5) 293-301, 1985 gives an account of this method.

An alternative and more precise method for color measurement and analysis uses the concept of uniform color space known as CIELAB in which a sample is analyzed mathematically in terms of its spectrophotometric curve, the nature of the illuminant under which it is viewed and the color vision of a standard observer. For a discussion of CIELAB and color measurement, see "Principles of Color Technology", 2nd Edition, p.25-110, Wiley-Interscience and "Optical Radiation Measurements", Volume 2, p.33-145, Academic Press.

In using CIELAB, colors can be expressed in terms of three parameters: L*, a* and b*, where L* is a lightness function, and a* and b* define a point in color space. Thus, a plot of a* v. b* values for a color

sample can be used to accurately show where that sample lies in color space, i.e., what its hue is. This allows different samples to be compared for hue if they have similar density and L* values.

In color proofing in the printing industry, it is important to be able to match the proofing ink references provided by the International Prepress Proofing Association. These ink references are density patches made with standard 4-color process inks and are known as SWOP (Specifications Web Offset Publications) Color References. For additional information on color measurement of inks for web offset proofing, see "Advances in Printing Science and Technology", Proceedings of the 19th International Conference of Printing Research Institutes, Eisenstadt, Austria, June 1987, J. T. Ling and R. Warner, p.55.

Thus, this invention relates to the use of a mixture of cyan, yellow and magenta dyes for thermal dye transfer imaging to approximate a hue match of the black SWOP Color Reference. The mixtures of dyes described in this invention provide a closer hue match to the SWOP standard and better transfer density than the preferred dye mixtures of U.S. Patent 4,923,846.

In U.S. Patent No. 4,816,435, a combination of thermally transferrable dyes is disclosed for use in producing black images. The dye types disclosed are di-and tri-cyanovinylanilines (for the yellow and magenta respectively) and phenol-based indoaniline cyan dyes. There is a problem with using these dyes in dye-donors in that the storage stability is not as good as one would like it to be. It is an object of this invention to provide a black dye-donor with good storage stability.

Accordingly, this invention relates to a black dye-donor element for thermal dye transfer comprising a support having thereon a dye layer comprising a mixture of cyan, yellow and magenta dyes dispersed in a polymeric binder, characterized in that at least one of the cyan dyes has the formula:

I 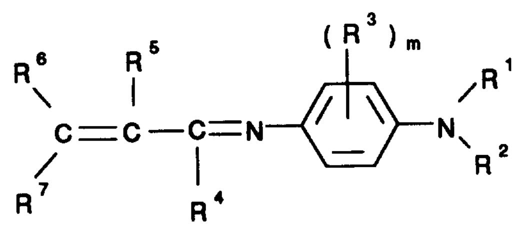

wherein:

$R^1$ and $R^2$ each independently represents hydrogen; an alkyl group having from 1 to 10 carbon atoms; a cycloalkyl group having from 5 to 7 carbon atoms; allyl; or such alkyl, cycloalkyl or allyl groups substituted with one or more groups such as alkyl (the number of carbon atoms in such alkyl substituent being included within the 1 to 10 carbon atom range for the alkyl group noted above), aryl, alkoxy, aryloxy, amino, halogen, nitro, cyano, thiocyano, hydroxy, acyloxy, acyl, alkoxycarbonyl, aminocarbonyl, alkoxycarbonyloxy, carbamoyloxy, acylamido, ureido, imido, alkylsulfonyl, arylsulfonyl, alkylsulfonamido, arylsulfonamido, alkylthio, arylthio, trifluoromethyl, etc., e.g., methyl, ethyl, propyl, isopropyl, butyl, pentyl, hexyl, methoxyethyl, benzyl, 2-methanesulfonamidoethyl, 2-hydroxyethyl,2-cyanoethyl, methoxycarbonylmethyl, cyclohexyl, cyclopentyl, phenyl, pyridyl, naphthyl, thienyl, pyrazolyl, p-tolyl, p-chlorophenyl, m-(N-methylsulfamoyl)phenylmethyl, methylthio, butylthio, benzylthio, methanesulfonyl, pentanesulfonyl, methoxy, ethoxy, 2-methane-sulfonamidoethyl, 2-hydroxyethyl, 2-cyanoethyl, methoxy-carbonylmethyl, imidazolyl, naphthyloxy, furyl, p-tolylsulfonyl, p-chlorophenylthio, m-(N-methyl sulfamoyl)phenoxy, ethoxy-carbonyl, methoxyethoxycarbonyl, phenoxy-carbonyl, acetyl, benzoyl, N,N-dimethyl-carbamoyl, dimethylamino, morpholino, anilino, pyrrolidino etc.; with the proviso that $R^1$ and $R^2$ cannot both be hydrogen;

or $R^1$ and $R^2$ can be joined together to form, along with the nitrogen to which they are attached, a 5- to 7-membered heterocyclic ring such as morpholine or pyrrolidine;

or either or both of $R^1$ and $R^2$ can be combined with an $R^3$ to form a 5- to 7-membered heterocyclic ring;

each $R^3$ independently represents hydrogen, substituted or unsubstituted alkyl, cycloalkyl or allyl as described above for $R^1$ and $R^2$; alkoxy, aryloxy, halogen, thiocyano, acylamino, ureido, alkylsulfonamido, arylsulfonamido, alkylthio, arylthio or trifluoromethyl;

or any two of $R^3$ may be combined together to form a 5- or 6-membered carbocyclic or heterocyclic ring; or one or two of $R^3$ may be combined with either or both of $R^1$ and $R^2$ to complete a 5-to 7-membered ring;

m is an integer of from 1 to 4;

$R^4$ represents hydrogen or an electron withdrawing group such as cyano, alkoxycarbonyl, aminocarbonyl, alkylsulfonyl, arylsulfonyl, acyl, nitro, etc.;

$R^5$ represents an electron withdrawing group such as those listed above for $R^4$; an aryl group having from 6 to 10 carbon atoms; a hetaryl group having from 5 to 10 atoms; or such aryl or hetaryl groups substituted with one or more groups such as are listed above for $R^1$ and $R^2$; $R^6$ and $R^7$ each independently represents an electron withdrawing group such as those described above for $R^4$; or $R^6$ and $R^7$ may be combined to form the residue of an active methylene compound such as a pyrazolin-5-one, a pyrazoline-3,5-dione, a thiohydantoin, a barbituric acid, a rhodanine, a furanone, an indandione, etc.; or $R^1$ and $R^2$ are $C_2H_5$, $R^3$ is $CH_3$ and $R^5$ is a 1-dibenzofuranyl group

and at least one of the yellow dyes has the formula:

II

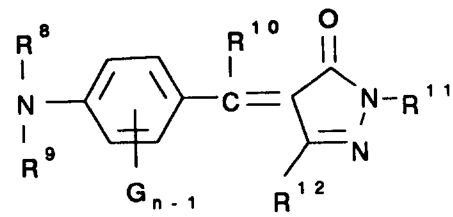

wherein:

$R^8$, $R^9$ and $R^{11}$ each independently represents a substituted or unsubstituted alkyl group of from 1 to 10 carbon atoms, such as those listed above for $R^1$; a cycloalkyl group of from 5 to 7 carbon atoms, such as those listed above for $R^1$; an allyl group, such as those listed above for $R^1$; or a substituted or unsubstituted aryl group having from 6 to 10 carbon atoms, such as phenyl, naphthyl, p-tolyl, m-chlorophenyl, p-methoxyphenyl, m-bromophenyl, o-tolyl, etc.;

or $R^8$ and $R^9$ can be joined together to form, along with the nitrogen to which they are attached, a 5-or 6-membered heterocyclic ring, such as a pyrrolidine or morpholine ring;

or either or both of $R^8$ and $R^9$ can be joined to the carbon atom of the benzene ring at a position ortho to the position of attachment of the anilino nitrogen to form a 5- or 6-membered ring, thus forming a polycyclic system such as 1,2,3,4-tetrahydroquinoline, julolidine, 2,3-dihydroindole, or benzomorpholine;

$R^{10}$ represents hydrogen; a substituted or unsubstituted alkyl group of from 1 to 10 carbon atoms, such as those listed above for $R^1$; a cycloalkyl group of from 5 to 7 carbon atoms, such as those listed above for $R^1$; an allyl group, such as those listed above for $R^1$; halogen; carbamoyl, such as N,N-dimethylcarbamoyl; or alkoxycarbonyl, such as ethoxycarbonyl or methoxyethoxy-carbonyl;

$R^{12}$ represents a substituted or unsubstituted alkoxy group having from 1 to 10 carbon atoms, such as methoxy, ethoxy, methoxyethoxy or 2-cyanoethoxy; a substituted or unsubstituted aryloxy group having from 6 to 10 carbon atoms, such as phenoxy, m-chlorophenoxy, or naphthoxy; $NHR^{13}$; $NR^{13}R^{14}$ or the atoms, such as O, $CH_2$, S, $NR^{13}$, etc., necessary to complete a 6-membered ring fused to the benzene ring;

$R^{13}$ and $R^{14}$ each independently represents any of the groups for $R^8$, or $R^{13}$ and $R^{14}$ may be joined together to form, along with the nitrogen to which they are attached, a 5-or 6-membered heterocyclic ring, such as a pyrrolidine or morpholine ring;

n is a positive integer from 2 to 5; and

G represents hydrogen, a substituted or unsubstituted alkyl or alkoxy group of from 1 to 10 carbon atoms, such as those listed above for $R^1$ and $R^{12}$; halogen; aryloxy; or represents the atoms necessary to complete a 5- or 6-membered ring, thus forming a fused ring system such as naphthalene, quinoline, isoquinoline or benzothiazole;

and at least one of the magenta dyes has the formula:

III

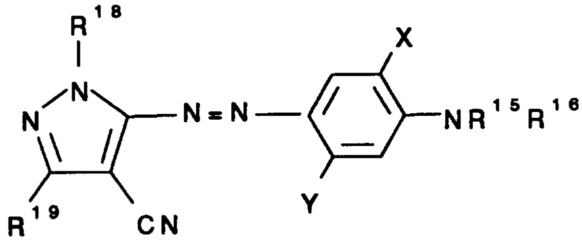

wherein:

$R^{15}$ is a substituted or unsubstituted alkyl or allyl group of from 1 to 10 carbon atoms, such as those listed above for $R^1$;

X is an alkoxy group of from 1 to 4 carbon atoms or represents the atoms which when taken together with $R^{16}$ forms a 5- or 6-membered substituted or unsubstituted ring;

$R^{16}$ is any of the groups for $R^{15}$ or represents the atoms which when taken together with X forms a substituted or unsubstituted 5- or 6-membered ring;

Y is $R^{15}$, an alkoxy group of from 1 to 4 carbon atoms, hydrogen, halogen, or $NHJR^{17}$;

$R^{17}$ is a substituted or unsubstituted alkyl group of from 1 to 10 carbon atoms such as those listed above for $R^1$, or a substituted or unsubstituted aryl group of from 6 to 10 carbon atoms such as phenyl, naphthyl, p-tolyl, m-chlorophenyl, p-methoxyphenyl, m-bromophenyl, o-tolyl, etc.; J is CO, $CO_2$, $-SO_2-$ or $CONR^{20}-$;

$R^{18}$ is a substituted or unsubstituted alkyl or allyl group of from 1 to 10 carbon atoms, such as those listed above for $R^1$, or a substituted or unsubstituted aryl group of from 6 to 10 carbon atoms, such as those listed above for $R^{17}$;

$R^{19}$ is hydrogen, cyano, a substituted or unsubstituted alkyl group of from 1 to 10 carbon atoms, such as those listed above for $R^1$, or a substituted or unsubstituted aryl group of from 6 to 10 carbon atoms, such as those listed above for $R^{17}$; and

$R^{20}$ is hydrogen or $R^{18}$.

In a preferred embodiment for compounds according to formula I employed in the invention, $R^4$, $R^6$ and $R^7$ are cyano. In another preferred embodiment for compounds according to formula I employed in the invention, $R^1$ is $C_2H_5$, $C_2H_4OH$, or $n\text{-}C_3H_7$. In yet another preferred embodiment for compounds according to formula I employed in the invention, $R^2$ is $C_2H_5$ or $n\text{-}C_3H_7$. In yet still another preferred embodiment for compounds according to formula I employed in the invention, $R^3$ is hydrogen, $OC_2H_5$, $CH_3$ or $NHCOCH_3$. In another preferred embodiment for compounds according to formula I employed in the invention, $R^5$ is $p\text{-}C_6H_4Cl$, $m\text{-}C_6H_4NO_2$ or naphthyl.

Copending EP-A-0 483 800 relates to a mixture of dyes for a magenta dye donor for thermal color proofing. Copending EP-A-0 483 793 relates to a mixture of dyes for a cyan dye donor for thermal color proofing. Copending EP-A-0 483 791 relates to a cyan azamethine dye-donor element for thermal dye transfer. Copending EP-A-0 484 814 relates to a magenta pyrazolylazoaniline dye-donor element for thermal dye transfer. Copending EP-A-0 483 801 relates to a yellow dye mixture for thermal color proofing.

Compounds included within the scope of formula I employed in the invention include the following:

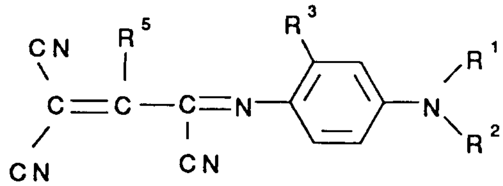

| Compound | $R^1$ | $R^2$ | $R^3$ | $R^5$ |
|---|---|---|---|---|
| 1 | $C_2H_5$ | $C_2H_5$ | $CH_3$ | $C_6H_5$ |
| 2 | $C_2H_5$ | $C_2H_5$ | H | $C_6H_5$ |
| 3 | $C_2H_4OH$ | $C_2H_5$ | $CH_3$ | $C_6H_5$ |
| 4 | $C_2H_5$ | $C_2H_5$ | $OC_2H_5$ | $C_6H_5$ |
| 5 | n-$C_3H_7$ | n-$C_3H_7$ | $NHCOCH_3$ | $C_6H_5$ |
| 6 | $C_2H_5$ | $C_2H_5$ | $CH_3$ | o-$C_6H_4OCH_3$ |
| 7 | $C_2H_5$ | $C_2H_5$ | $CH_3$ | p-$C_6H_4OCH_3$ |
| 8 | $C_2H_5$ | $C_2H_5$ | $CH_3$ | p-$C_6H_4Cl$ |
| 9 | $C_2H_5$ | $C_2H_5$ | $CH_3$ | m-$C_6H_4NO_2$ |
| 10 | $C_2H_5$ | $C_2H_5$ | $CH_3$ | 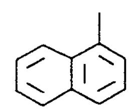 |
| 11 | $C_2H_5$ | $C_2H_5$ | $CH_3$ | 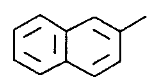 |
| 12 | $C_2H_5$ | $C_2H_5$ | $CH_3$ | 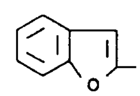 |
| 13 | $C_2H_5$ | $C_2H_5$ | H | 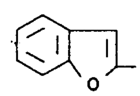 |
| 14 | $C_2H_5$ | $C_2H_5$ | $CH_3$ | p-$C_6H_4F$ |
| 15 | $C_2H_5$ | $C_2H_5$ | $CH_3$ | o-$C_6H_4Cl$ |
| 16 | $C_2H_5$ | $C_2H_5$ | $CH_3$ | p-$C_6H_4CN$ |
| 17 | $C_2H_5$ | $C_2H_5$ | $CH_3$ | 3,4-$C_6H_3Cl_2$ |
| 18 | $C_2H_5$ | $C_2H_5$ | $CH_3$ | 2,4-$C_6H_3Cl_2$ |
| 19 | $C_2H_5$ | $C_2H_5$ | $CH_3$ | 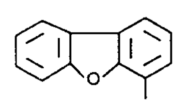 |

| Compound | $R^1$ | $R^2$ | $R^3$ | $R^5$ |
|---|---|---|---|---|
| 20 | $C_2H_5$ | $C_2H_5$ | $CH_3$ | 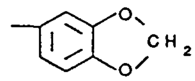 |
| 21 | $C_2H_5$ | $C_2H_5$ | $CH_3$ | 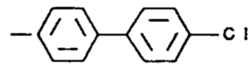 |
| 22 | $C_2H_4OH$ | $C_2H_5$ | $CH_3$ | p-$C_6H_4Cl$ |
| 23 | $C_2H_4NH$-$SO_2CH_3$ | $C_2H_5$ | $CH_3$ | p-$C_6H_4Cl$ |

24

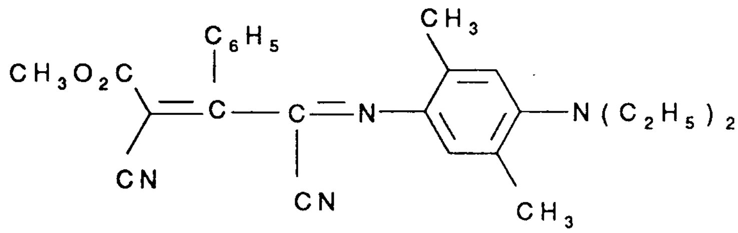

25

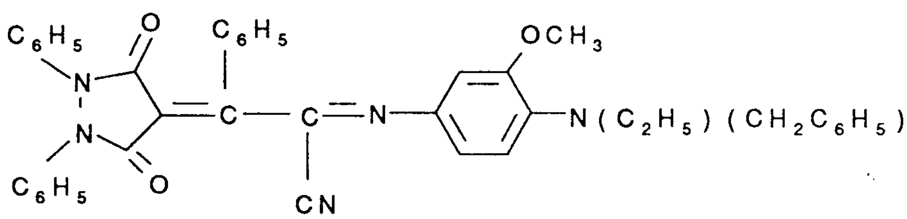

26

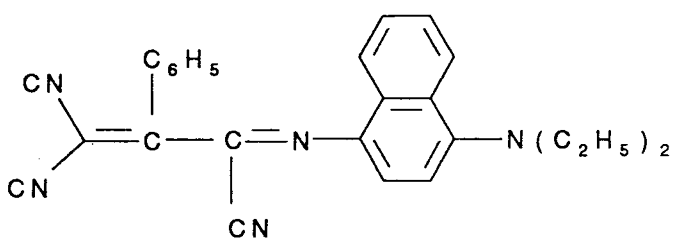

27

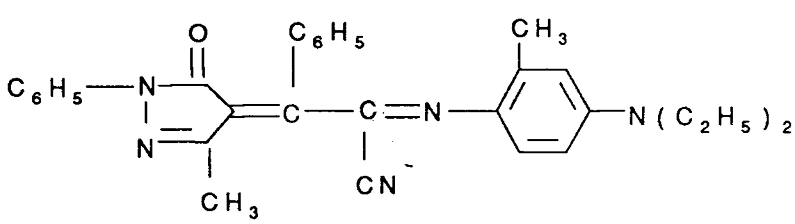

The above dyes may be prepared analogously to the method described in Example 1 below.

In a preferred embodiment for compounds according to formula II employed in the invention, $R^{11}$ is phenyl; $R^{12}$ is ethoxy or $NHR^{13}$, wherein $R^{13}$ is methyl or phenyl; n is 1; and $R^{10}$ is hydrogen.

In another preferred embodiment for compounds according to formula II employed in the invention, $R^{12}$ is O and completes a 6-membered ring fused to the benzene ring. In another preferred embodiment for

compounds according to formula II employed in the invention, $R^{12}$ is $NR^{13}R^{14}$, wherein each $R^{13}$ and $R^{14}$ is methyl or $R^{13}$ is ethyl and $R^{14}$ is phenyl.

In another preferred embodiment for compounds according to formula II employed in the invention, $R^{12}$ is $NR^{13}R^{14}$, wherein $R^{13}$ and $R^{14}$ are joined together to form, along with the nitrogen to which they are attached, a pyrrolidine or morpholine ring.

The compounds of formula II employed in the invention above may be prepared by any of the processes disclosed in U.S. Patent 4,866,029.

Compounds included within the scope of formula II employed in the invention include the following:

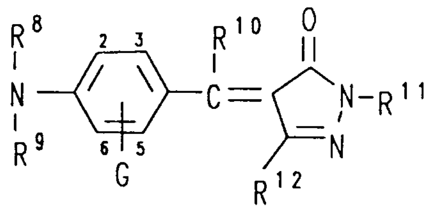

| Cmpd. | G | $R^8$ | $R^9$ | $R^{10}$ | $R^{11}$ | $R^{12}$ |
|---|---|---|---|---|---|---|
| II-1 | H | $C_2H_5$ | $C_2H_5$ | H | $C_6H_5$ | $N(CH_3)_2$ |
| II-2 | H | $CH_3$ | $CH_3$ | H | $C_6H_5$ | $N(CH_3)_2$ |
| II-3 | H | $n\text{-}C_4H_9$ | $n\text{-}C_4H_9$ | H | $C_6H_5$ | $N(CH_3)_2$ |
| II-4 | $3\text{-}CH_3$ | $C_2H_5$ | $CF_3CH_2O_2CCH_2$ | H | $C_6H_5$ | $N(CH_3)_2$ |
| II-5 | H | 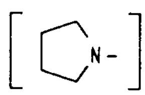 | | H | $C_6H_5$ | $N(CH_3)_2$ |
| II-6 | H | $C_2H_5$ | $C_2H_5$ | H | $C_6H_5$ | $NHC_6H_5$ |
| II-7 | H | $C_2H_5$ | $C_2H_5$ | H | $C_6H_5$ | 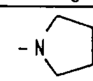 |
| II-8 | H | $C_2H_5$ | $C_2H_5$ | H | $C_6H_5$ | 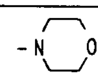 |
| II-9 | H | $C_2H_5$ | $C_2H_5$ | H | $C_6H_5$ | $NHCH_3$ |
| II-10 | H | $C_2H_5$ | $C_2H_5$ | H | $C_6H_5$ | $N(C_2H_5)$-$(C_6H_5)$ |
| II-11 | $3\text{-}OCH_3$ | $C_2H_5$ | $C_2H_5$ | H | $C_6H_5$ | $N(CH_3)_2$ |
| II-12 | H | $n\text{-}C_4H_9$ | $n\text{-}C_4H_9$ | H | $C_6H_5$ | $OC_2H_5$ |
| II-13 | 3-Cl | $CH_3$ | $C_2H_5O_2CCH_2$ | H | $C_{10}H_9$ | $N(CH_3)_2$ |
| II-14 | H | 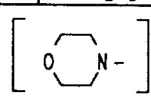 | | H | $4\text{-}Cl\text{-}C_6H_4$ | $OCH_3$ |
| II-15 | $3\text{-}CH_3$ | $ClC_2H_4$ | $ClC_2H_4$ | H | $CH_2C_6H_5$ | $OC_6H_5$ |
| II-16 | $3\text{-}C_2H_5$ | $C_6H_5CH_2$ | $C_2H_5$ | H | $CH_3$ | $N(CH_3)_2$ |
| II-17 | $2,5\text{-}(OCH_3)_2$ | $CH_3$ | $CH_3$ | H | $3,5\text{(Cl)}_2\text{-}C_6H_3$ | $NHCH_3$ |
| II-18 | H | $CH_3$ | $CH_3$ | $CO_2C_2H_5$ | $C_6H_5$ | $N(CH_3)_2$ |
| II-19 | H | $CH_3$ | $CH_3$ | Cl | $C_6H_5$ | $N(CH_3)_2$ |
| II-20 | $3\text{-}CH_3$ | $C_2H_5$ | $C_6H_5CH_2$ | H | $C_6H_5$ | $OC_2H_5$ |
| II-21 | H | $C_2H_5$ | $C_2H_5$ | H | $C_6H_5$ | $OC_3H_7\text{-}i$ |
| II-22 | $3\text{-}CH_3$ | $C_2H_5$ | $C_2H_5$ | H | $C_6H_5$ | $OC_2H_5$ |

II-23

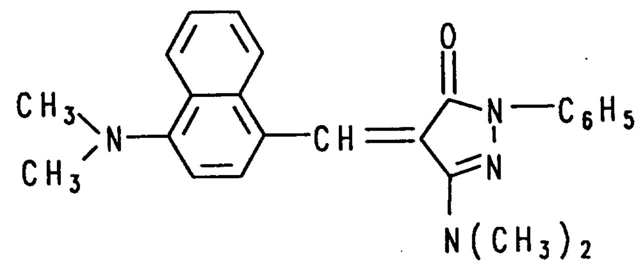

II-24

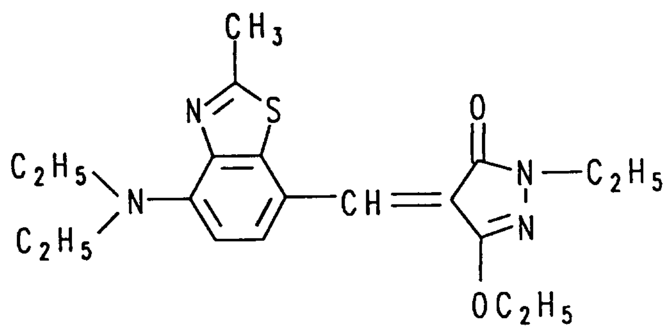

II-25

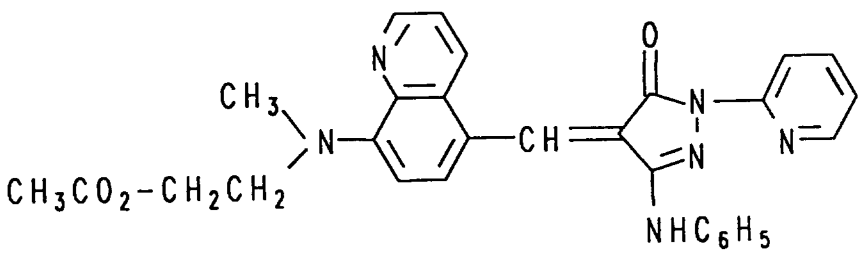

II-26

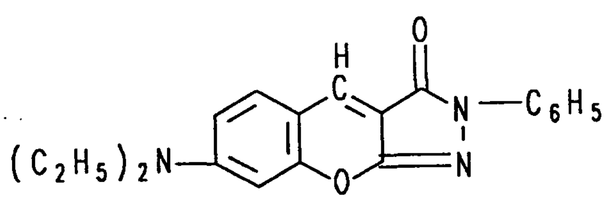

II-27

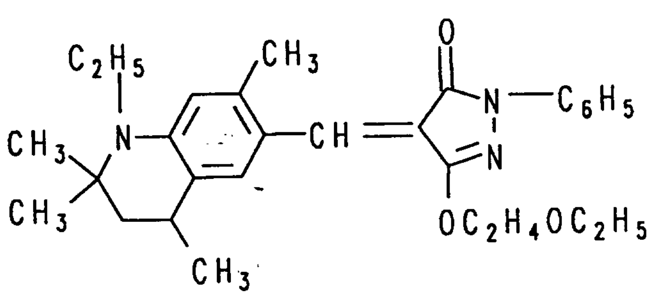

II-28 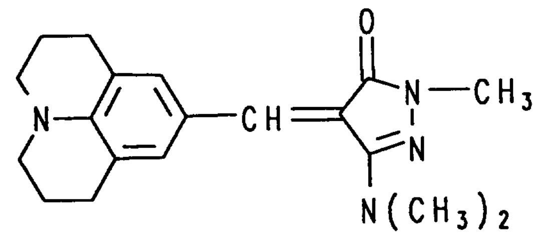

II-29 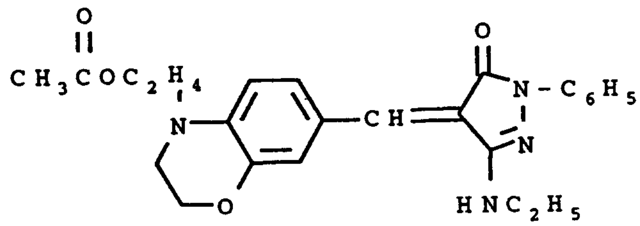

II-30 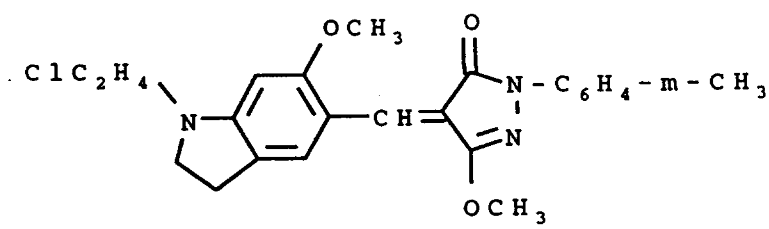

In a preferred embodiment for compounds according to formula III employed in the invention, $R^{15}$ and $R^{16}$ are each ethyl, X is $OCH_3$, J is CO, $R^{17}$ and $R^{18}$ are each $CH_3$, and $R^{19}$ is $C_4H_9$-t. In another preferred embodiment of the invention, $R^{15}$ and $R^{16}$ are each ethyl, X is $OCH_3$, J is CO, $R^{17}$ is $CH_3$, $R^{18}$ is $CH_2CHOHCH_3$, and $R^{19}$ is $C_4H_9$-t.

The compounds of formula III above employed in the invention may be prepared by any of the processes disclosed in U.S. Patent 3,336,285, Br 1,566,985, UK 1,531,071 and Dyes and Pigments, Vol 3, 81 (1982).

Magenta dyes included within the scope of formula III include the following:

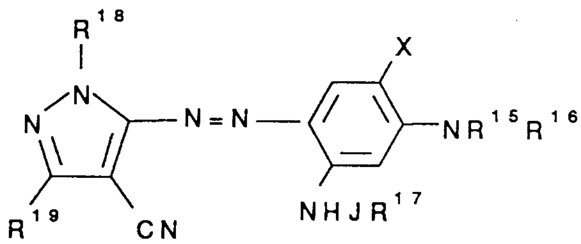

| Dye | $R^{15}$ | $R^{16}$ | $R^{17}$ | $R^{18}$ | $R^{19}$ | X | J |
|---|---|---|---|---|---|---|---|
| III-1 | $C_2H_5$ | $C_2H_5$ | $CH_3$ | $CH_3$ | $C_4H_9$-t | $OCH_3$ | CO |
| III-2 | $C_2H_5$ | $C_2H_5$ | $CH_3$ | $CH_2CH$-$OHCH_3$ | $C_4H_9$-t | $OCH_3$ | CO |
| III-3 | $C_3H_7$ | $C_3H_7$ | $CH_3$ | $CH_3$ | $C_4H_9$-t | $OCH_3$ | CO |
| III-4 | $C_2H_5$ | $C_2H_5$ | $C_4H_9$-t | $CH_3$ | $CH_3$ | $OCH_3$ | CO |
| III-5 | $C_2H_5$ | $C_2H_5$ | $CH_3$ | $C_2H_5$ | $C_4H_9$-t | $OC_2H_5$ | $SO_2$ |
| III-6 | $C_2H_5$ | $C_2H_5$ | $C_2H_5$ | $CH_3$ | $CH_3$ | $OC_2H_5$ | CO |
| III-7 | $C_2H_5$ | $C_3H_7$ | $CH_3$ | $CH_3$ | $C_4H_9$-t | $OCH_3$ | CO |
| III-8 | $C_2H_5$ | $C_2H_5$ | $CH_3$ | $CH_3$ | $C_4H_9$-t | $OCH_3$ | $CO_2$ |
| III-9 | $C_2H_5$ | $C_2H_5$ | $C_6H_5$ | $C_3H_7$ | $C_4H_9$-t | $OC_2H_5$ | $SO_2$ |
| III-10 | $CH_2$=CH-$CH_2$ | $CH_2$=CH-$CH_2$ | $CH_3$ | $CH_2C_6H_5$ | $C_4H_9$-t | $OCH_3$ | CO |
| III-11 | $C_3H_7$ | $C_3H_7$ | $C_2H_5$ | $CH_2CN$ | CN | $OC_3H_7$ | CO |
| III-12 | $C_3H_7$ | $C_3H_7$ | $C_2H_5$ | $C_6H_5$ | $CH_3$ | $OC_3H_7$ | $SO_2$ |

III-13

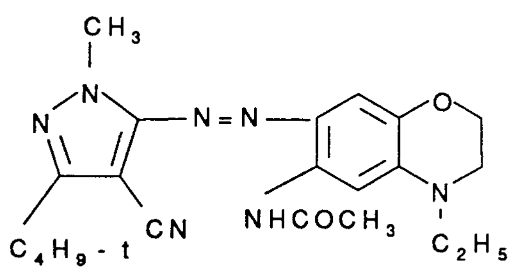

III-14
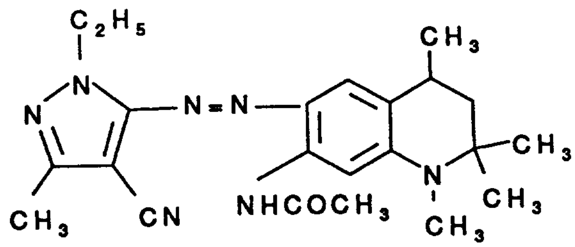

III-15
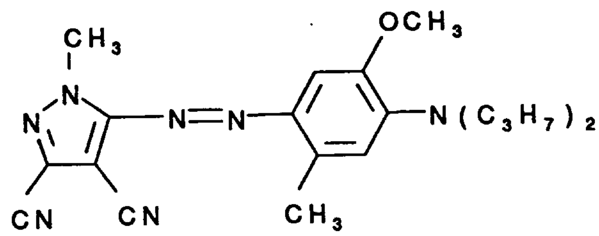

III-16
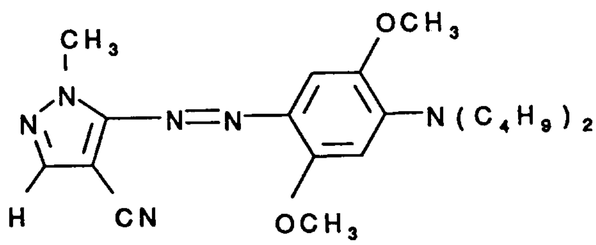

The use of dye mixtures in the dye-donor of the invention permits a wide selection of hue and color that enables a close hue match to a variety of printing inks and also permits easy transfer of images one or more times to a receiver if desired. The use of dyes also allows easy modification of image density to any desired level. The dyes of the dye-donor element of the invention may be used at a coverage of from about 0.05 to about 1 g/m$^2$.

The dyes in the dye-donor of the invention are dispersed in a polymeric binder such as a cellulose derivative, e.g., cellulose acetate hydrogen phthalate, cellulose acetate, cellulose acetate propionate, cellulose acetate butyrate, cellulose triacetate or any of the materials described in U. S. Patent 4,700,207; a polycarbonate; polyvinyl acetate; poly(styrene-co-acrylonitrile); a poly(sulfone) or a poly(phenylene oxide). The binder may be used at a coverage of from about 0.1 to about 5 g/m$^2$.

The dye layer of the dye-donor element may be coated on the support or printed theron by a printing technique such as a gravure process.

Any material can be used as the support for the dye-donor element of the invention provided it is dimensionally stable and can withstand the heat of the laser or thermal head. Such materials include polyesters such as poly(ethylene terephthalate); polyamides; polycarbonates; cellulose esters; fluorine polymers; polyethers; polyacetals; polyolefins; and polyimides. The support generally has a thickness of from about 5 to about 200 $\mu$m. It may also be coated with a subbing layer, if desired, such as those materials described in U. S. Patents 4,695,288 or 4,737,486.

The reverse side of the dye-donor element may be coated with a slipping layer to prevent the printing head from sticking to the dye-donor element. Such a slipping layer would comprise either a solid or liquid lubricating material or mixtures thereof, with or without a polymeric binder or a surface active agent. Preferred lubricating materials include oils or semi-crystalline organic solids that melt below 100 °C such as poly(vinyl stearate), beeswax, perfluorinated alkyl ester polyethers, poly(capro-lactone), silicone oil, poly-(tetrafluoroethylene), carbowax, poly(ethylene glycols), or any of those materials disclosed in U. S. Patents 4,717,711; 4,717,712; 4,737,485; and 4,738,950. Suitable polymeric binders for the slipping layer include poly(vinyl alcohol-co-butyral), poly(vinyl alcohol-co-acetal), poly(styrene), poly(vinyl acetate), cellulose acetate butyrate, cellulose acetate propionate, cellulose acetate or ethyl cellulose.

The amount of the lubricating material to be used in the slipping layer depends largely on the type of lubricating material, but is generally in the range of about .001 to about 2 g/m$^2$. If a polymeric binder is

employed, the lubricating material is present in the range of 0.1 to 50 weight %, preferably 0.5 to 40, of the polymeric binder employed.

The dye-receiving element that is used with the dye-donor element of the invention usually comprises a support having thereon a dye image-receiving layer. The support may be a transparent film such as a poly-(ether sulfone), a polyimide, a cellulose ester such as cellulose acetate, a poly(vinyl alcohol-co-acetal) or a poly(ethylene terephthalate). The support for the dye-receiving element may also be reflective such as baryta-coated paper, polyethylene-coated paper, an ivory paper, a condenser paper or a synthetic paper such as duPont Tyvek®. Pigmented supports such as white polyester (transparent polyester with white pigment incorporated therein) may also be used.

The dye image-receiving layer may comprise, for example, a polycarbonate, a polyurethane, a polyester, polyvinyl chloride, poly(styrene-co-acrylonitrile), poly(caprolactone), a poly(vinyl acetal) such as poly(vinyl alcohol-co-butyral), poly(vinyl alcohol-co-benzal), poly(vinyl alcohol-co-acetal) or mixtures thereof. The dye image-receiving layer may be present in any amount which is effective for the intended purpose. In general, good results have been obtained at a concentration of from about 1 to about 5 $g/m^2$.

As noted above, the dye-donor elements of the invention are used to form a dye transfer image. Such a process comprises imagewise-heating a dye-donor element as described above and transferring a dye image to a dye-receiving element to form the dye transfer image.

The dye-donor element of the invention may be used in sheet form or in a continuous roll or ribbon. If a continuous roll or ribbon is employed, it may have only the dyes thereon as described above or may have alternating areas of other different dyes or combinations, such as sublimable cyan and/or yellow and/or black or other dyes. Such dyes are disclosed in U. S. Patents 4,541,830. Thus, one-, two-, three- or four-color elements (or higher numbers also) are included within the scope of the invention.

A laser may also be used to transfer dye from the dye-donor elements of the invention. When a laser is used, it is preferred to use a diode laser since it offers substantial advantages in terms of its small size, low cost, stability, reliability, ruggedness, and ease of modulation. In practice, before any laser can be used to heat a dye-donor element, the element must contain an infrared-absorbing material, such as carbon black, cyanine infrared absorbing dyes as described in U.S. Patent 4,973,572, or other materials as described in the following U.S. Patents 4,948,777, 4,950,640, 4,950,639, 4,948,776, 4,948,778, 4,942,141, 4,952,552, 4,912,093, and in EP-A-0 403 934, EP-A-0 407 744, EP-A-0 403 933 and EP-A-0 408 908 (the last four publications being state of the art according to Article 54(3) EPC). The laser radiation is then absorbed into the dye layer and converted to heat by a molecular process known as internal conversion. Thus, the construction of a useful dye layer will depend not only on the hue, transferability and intensity of the image dyes, but also on the ability of the dye layer to absorb the radiation and convert it to heat.

Spacer beads may be employed in a separate layer over the dye layer of the dye-donor in the above-described laser process in order to separate the dye-donor from the dye-receiver during dye transfer, thereby increasing the uniformity and density of the transferred image. That invention is more fully described in U.S. Patent 4,772,582. Alternatively, the spacer beads may be employed in the receiving layer of the dye-receiver as described in U.S. Patent 4,876,235. The spacer beads may be coated with a polymeric binder if desired.

The use of an intermediate receiver with subsequent retransfer to a second receiving element may also be employed in the invention. A multitude of different substrates can be used to prepare the color proof (the second receiver) which is preferably the same substrate used for the printing press run. Thus, this one intermediate receiver can be optimized for efficient dye uptake without dye-smearing or crystallization.

Examples of substrates which may be used for the second receiving element (color proof) include the following: Flo Kote Cove® (S. D. Warren Co.), Champion Textweb® (Champion Paper Co.), Quintessence Gloss® (Potlatch Inc.), Vintage Gloss® (Potlatch Inc.), Khrome Kote® (Champion Paper Co.), Consolith Gloss® (Consolidated Papers Co.), Ad-Proof Paper® (Appleton Papers, Inc.) and Mountie Matte® (Potlatch Inc.).

As noted above, after the dye image is obtained on a first dye-receiving element, it is retransferred to a second dye image-receiving element. This can be accomplished, for example, by passing the two receivers between a pair of heated rollers. Other methods of retransferring the dye image could also be used such as using a heated platen, use of pressure and heat, external heating, etc.

Also as noted above, in making a color proof, a set of electrical signals is generated which is representative of the shape and color of an original image. This can be done, for example, by scanning an original image, filtering the image to separate it into the desired additive primary colors-red, blue and green, and then converting the light energy into electrical energy. The electrical signals are then modified by computer to form the color separation data which is used to form a halftone color proof. Instead of scanning an original object to obtain the electrical signals, the signals may also be generated by computer. This

process is described more fully in Graphic Arts Manual, Janet Field ed., Arno Press, New York 1980 (p. 358ff).

A thermal dye transfer assemblage of the invention comprises

a) a dye-donor element as described above, and

b) a dye-receiving element as described above, the dye-receiving element being in a superposed relationship with the dye-donor element so that the dye layer of the donor element is in contact with the dye image-receiving layer of the receiving element.

The above assemblage comprising these two elements may be preassembled as an integral unit when a monochrome image is to be obtained. This may be done by temporarily adhering the two elements together at their margins. After transfer, the dye-receiving element is then peeled apart to reveal the dye transfer image.

When a three-color image is to be obtained, the above assemblage is formed three times using different dye-donor elements. After the first dye is transferred, the elements are peeled apart. A second dye-donor element (or another area of the donor element with a different dye area) is then brought in register with the dye-receiving element and the process repeated. The third color is obtained in the same manner.

The following examples are provided to illustrate the invention.

Example 1 Synthesis of Compound 1

A. Synthesis of 2-phenyl-1,1,3-tricyano-propene (intermediate for Compound 1)

A mixture of benzoylacetonitrile (9.94 g, 0.0685 mole), malononitrile (11.3 g, 0.17 mole), ammonium acetate (5.4 g, 0.07 mole) and ethanol (100 mℓ) was heated at reflux for 1.5 hours. After cooling to room temperature, the reaction mixture was diluted with water (50 mℓ) and concentrated hydrochloric acid (7.5 mℓ) was added dropwise over 5 minutes. The resulting precipitate was collected by filtration and washed with water and ligroin. The yield was 10.0 g (76%), m.p. 92-98°C.

B. Synthesis of Compound 1: 2-phenyl-1,1,3-tricyano-3-(4-diethylamino-2-methylphenylimino)-propene

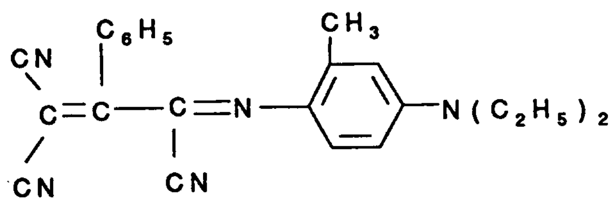

A mixture of the phenyltricyanopropene above (0.58 g, 0.003 mole) and 2-amino-5-diethylaminotoluene hydrochloride (0.64 g, 0.003 mole) in a solution of methanol (30 mℓ) and water (10 mℓ) was treated with concentrated ammonium hydroxide (1.8 mℓ). To this mixture was slowly added a solution of potassium ferricyanide (4.94 g, 0.015 mole) in water (20 mℓ), keeping the temperature below 20°C with external cooling. After stirring for 2 hours, the reaction mixture was diluted with water (100 mℓ) and the resulting precipitate was collected by filtration and washed well with water. The crude dye was crystallized from methanol to yield 0.85 g (81%) of a dark green powder. The dye had a lambda max of 604 nm with a molar extinction coefficient of 44,200 (in acetone solution).

Example 2

A black dye-donor element was prepared by coating on a 100 µm poly(ethylene terephthalate) support:

1) a subbing layer of poly(acrylonitrile-co-vinylidene chloride-co-acrylic acid) (0.054 g/m$^2$) (14:79:7 wt. ratio); and

2) a dye layer containing a mixture of cyan dye 8, yellow dye II-1 and magenta dye III-2 illustrated above, (each at 0.22 g/m$^2$) and the cyanine infrared absorbing dye illustrated below (0.054 g/m$^2$) in a cellulose acetate propionate binder (2.5% acetyl, 45% propionyl) (0.27 g/m$^2$) coated from dichloromethane.

Comparison dye-donors using a mixture of cyan, yellow and magenta dyes of the prior art as identified below, at a total coverage of 0.66 g/m$^2$, were also prepared.

Cyanine Infrared Absorbing Dye

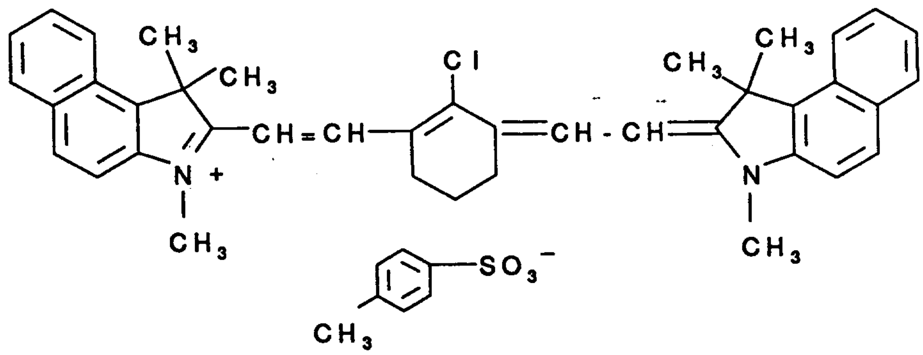

An intermediate dye-receiving element was prepared by coating on an unsubbed 100 μm thick poly(ethylene terephthalate) support a layer of crosslinked poly(styrene-co-divinylbenzene) beads (12 μm average diameter) (0.11 g/m$^2$), triethanolamine (0.09 g/m$^2$) and DC-510® Silicone Fluid (Dow Corning Company) (0.01 g/m$^2$) in a Butvar® 76 binder, a poly(vinyl alcohol-co-butyral), (Monsanto Company) (4.0 g/m$^2$) from 1,1,2-trichloroethane and dichloromethane.

Single color black images were printed as described below from dye-donors onto a receiver using a laser imaging device as described in U.S. Patent 4,876,235. The laser imaging device consisted of a single diode laser connected to a lens assembly mounted on a translation stage and focused onto the dye-donor layer.

The dye-receiving element was secured to the drum of the diode laser imaging device with the receiving layer facing out. The dye-donor element was secured in face-to-face contact with the receiving element.

The diode laser used was a Spectra Diode Labs No. SDL-2430-H2, having an integral, attached optical fiber for the output of the laser beam, with a wavelength of 816 nm and a nominal power output of 250 milliwatts at the end of the optical fiber. The cleaved face of the optical fiber (100 μm core diameter) was imaged onto the plane of the dye-donor with a 0.33 magnification lens assembly mounted on a translation stage giving a nominal spot size of 33 μm and a measured power output at the focal plane of 115 milliwatts.

The drum, 312 mm in circumference, was rotated at 500 rev/min and the imaging electronics were activated. The translation stage was incrementally advanced across the dye-donor by means of a lead screw turned by a microstepping motor, to give a center-to-center line distance of 14 μm (714 lines per centimeter, or 1800 lines per inch). For a continuous tone stepped image, the current supplied to the laser was modulated from full power to 16% power in 4% increments.

After the laser had scanned approximately 12 mm, the laser exposing device was stopped and the intermediate receiver was separated from the dye donor. The intermediate receiver containing the stepped dye image was laminated to Ad-Proof Paper® (Appleton Papers, Inc.) 60 pound stock paper by passage through a pair of rubber rollers heated to 120°C. The polyethylene terephthalate support was then peeled away leaving the dye image and polyvinyl alcohol-co-butyral firmly adhered to the paper. The paper stock was chosen to represent the substrate used for a printed ink image obtained from a printing press.

The Status T density of each of the stepped images was read using an X-Rite® 418 Densitometer to find the single step image within 0.05 density unit of the SWOP Color Reference. For the black standard, this density was 1.6.

The a* and b* values of the selected step image of transferred dye-mixture was compared to that of the SWOP Color Reference by reading on an X-Rite® 918 Colorimeter set for D50 illuminant and a 10 degree observer. The L* reading was checked to see that it did not differ appreciably from the reference. The a* and b* readings were recorded and the distance from the SWOP Color Reference calculated as the square root of the sum of differences squared for a* and b*:

i.e. $\sqrt{(a^*_e - a^*_s)^2 + (b^*_e - b^*_s)^2}$

e = experiment (transferred dye)
s = SWOP Color Reference

In addition, the above dye-donors were evaluated for storage stability by comparing transmission spectra of the donor before and after incubation at 50°C/50% RH for 4 days.

The following results were obtained:

Table 1

| Dyes (Weight Ratio) | a* | b* | Distance From Reference | Density @ 500 rev/min | Storage Stability |
|---|---|---|---|---|---|
| SWOP | 1.5 | 2.0 | | | |
| 8/II-1/III-2 (33:33:34) | 0.5 | -0.5 | 2.5 | 1.6 | good |
| 8/II-1/III-1 (37:26:37) | 0.5 | 1 | 1 | 1.8 | good |
| 8/II-22/III-1 (37:23:40) | 3.5 | 1 | 2 | 1.4 | good |
| 1/II-1/III-2 (33:33:34) | 2 | -3 | 5 | 1.7 | good |
| 1/II-22/III-2 (33:28:39) | 5 | -2 | 5 | 1.5 | good |
| Control 1[a] (46:27:27) | -1.2[b] | -5.4[b] | 8.0 | 0.8 | good |
| Control 2[c] (54:21:25) | -2.4 | -1.5 | 5.5 | 1.6 | poor[d] |

[a]Similar to Table C-17 from U.S. Patent 4,923,846, a mixture of Solvent Blue 36, Solvent Red 19 and Foron Brilliant Yellow S-6GL (structures below).
[b]The drum speed was reduced to 400 rev/min so that sufficient density could be obtained to allow a valid hue comparison.
[c]Similar to Example 1 of U.S. patent 4,186,435 (dye structures below).
[d]At room temperature after two days, some of the magenta dye sublimed out of the coating onto an adjacent piece of paper. In addition, after incubation, at least 75% of the absorption due to the cyan dye was lost.

Control 1

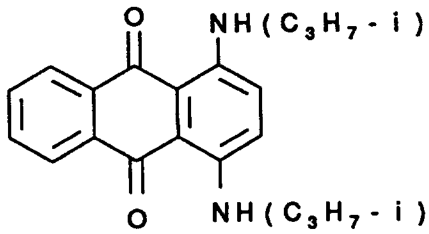

SOLVENT BLUE 36

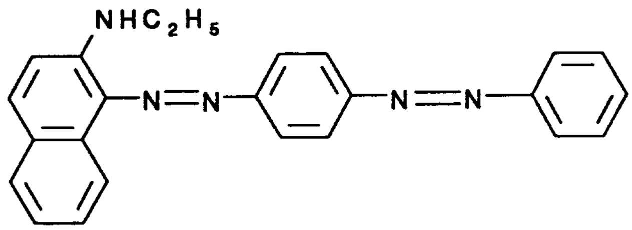

SOLVENT RED 19

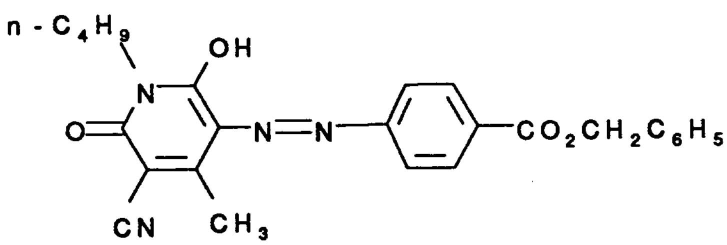

YELLOW S-6GL

Control 2

Cyan

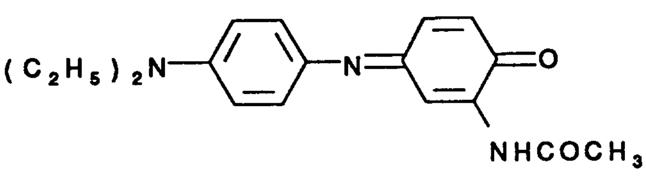

Magenta Magenta

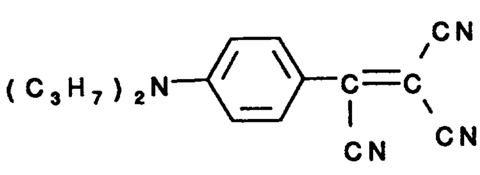

Yellow

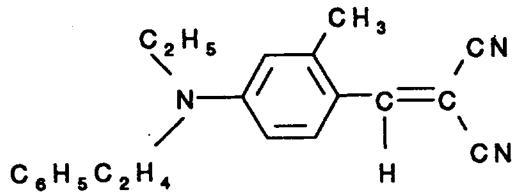

The above results indicate that by using a mixture of cyan, magenta and yellow dyes according to the invention in an appropriate ratio, a hue closely corresponding to that of the black SWOP Color Reference was obtained, in comparison to the controls of the prior art which were further away from the SWOP Color Reference.

Although Control 2 yields high transfer density and a reasonable color match, the storage stability was poor as noted above. Although Control 1 had good storage stability, it was difficult to obtain useful densities.

## Claims

**1.** A black dye-donor element for thermal dye transfer comprising a support having thereon a dye layer comprising a mixture of at least one cyan, magenta and yellow dyes dispersed in a polymeric binder, characterized in that at least one of the cyan dyes has the formula:

I 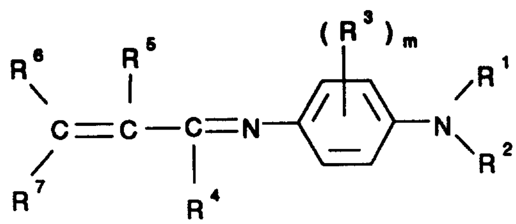

wherein:

$R^1$ and $R^2$ each independently represents hydrogen; a substituted or unsubstituted alkyl group having from 1 to 10 carbon atoms; a substituted or unsubstituted cycloalkyl group having from 5 to 7 carbon atoms or a substituted or unsubstituted allyl group; with the proviso that $R^1$ and $R^2$ cannot both be hydrogen;

or $R^1$ and $R^2$ can be joined together to form, along with the nitrogen to which they are attached, a 5- to 7-membered heterocyclic ring;

or either or both of $R^1$ and $R^2$ can be combined with an $R^3$ to form a 5- to 7-membered heterocyclic ring;

each $R^3$ independently represents hydrogen, substituted or unsubstituted alkyl, cycloalkyl or allyl as described above for $R^1$ and $R^2$, alkoxy, aryloxy, halogen, thiocyano, acylamino, ureido, alkylsulfonamido, arylsulfonamido, alkylthio, arylthio or trifluoromethyl;

or any two of $R^3$ may be combined together to form a 5- or 6-membered carbocyclic or heterocyclic ring; or one or two of $R^3$ may be combined with either or both of $R^1$ and $R^2$ to complete a 5-to 7-membered ring;

m is an integer of from 0 1 to 4;

$R^4$ represents hydrogen or an electron withdrawing group;

$R^5$ represents an electron withdrawing group, a substituted or unsubstituted aryl group having from 6 to 10 carbon atoms; a substituted or unsubstituted hetaryl group having from 5 to 10 atoms;

$R^6$ and $R^7$ each independently represents an electron withdrawing group; and

$R^6$ and $R^7$ may be combined to form the residue of an active methylene compound; or $R^1$ and $R^2$ are $C_2H_5$, $R^3$ is $CH_3$ and $R^5$ is a 1-dibenzofuranyl group

and at least one of the yellow dyes has the formula:

II

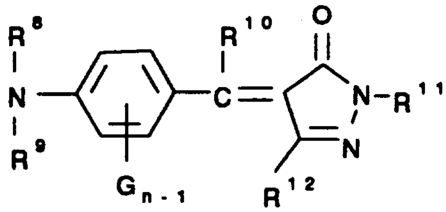

wherein:

$R^8$, $R^9$ and $R^{11}$ each independently represents a substituted or unsubstituted alkyl group of from 1 to 10 carbon atoms; a cycloalkyl group of from 5 to 7 carbon atoms; a substituted or unsubstituted allyl group; or an a substituted or unsubstituted aryl group having from 6 to 10 carbon atoms;

or $R^8$ and $R^9$ can be joined together to form, along with the nitrogen to which they are attached, a 5-or 6-membered heterocyclic ring;

or either or both of $R^8$ and $R^9$ can be joined to the carbon atom of the benzene ring at a position ortho to the position of attachment of the anilino nitrogen to form a 5- or 6-membered ring, thus forming a polycyclic system;

$R^{10}$ represents hydrogen; a substituted or unsubstituted alkyl group of from 1 to 10 carbon atoms; a cycloalkyl group of from 5 to 7 carbon atoms; a substituted or unsubstituted allyl group; carbamoyl; or alkoxycarbonyl;

$R^{12}$ represents a substituted or unsubstituted alkoxy group having from 1 to 10 carbon atoms; a substituted or unsubstituted aryloxy group having from 6 to 10 carbon atoms; $NHR^{13}$; $NR^{13}R^{14}$ or the atoms necessary to complete a 6-membered ring fused to the benzene ring;

$R^{13}$ and $R^{14}$ each independently represents any of the groups for $R^8$; or $R^{13}$ and $R^{14}$ may be joined together to form, along with the nitrogen to which they are attached, a 5-or 6-membered heterocyclic ring;

n is a positive integer from 2 to 5; and

G represents hydrogen, a substituted or unsubstituted alkyl or alkoxy group of from 1 to 10 carbon atoms; halogen; aryloxy; or represents the atoms necessary to complete a 5- or 6-membered ring, thus forming a fused ring system;

and at least one of the magenta dyes has the formula:

III

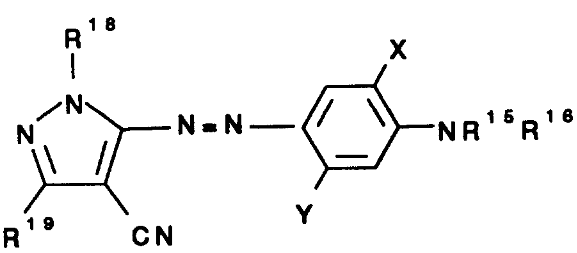

wherein:

$R^{15}$ is a substituted or unsubstituted alkyl or allyl group of from 1 to 10 carbon atoms;

X is an alkoxy group of from 1 to 4 carbon atoms or represents the atoms which when taken together with $R^{16}$ forms a substituted or unsubstituted 5- or 6-membered ring;

$R^{16}$ is any of the groups for $R^{15}$ or represents the atoms which when taken together with X forms a substituted or unsubstituted 5- or 6-membered ring;

Y is $R^{15}$, an alkoxy group of from 1 to 4 carbon atoms, hydrogen, halogen, or $NHJR^{17}$;

$R^{17}$ is a substituted or unsubstituted alkyl group of from 1 to 10 carbon atoms, or a substituted or unsubstituted aryl group of from 6 to 10 carbon atoms;

J is CO, $CO_2$, $-SO_2-$ or $CONR^{20}-$;

$R^{18}$ is a substituted or unsubstituted alkyl or allyl group of from 1 to 10 carbon atoms, or a substituted or unsubstituted aryl group of from 6 to 10 carbon atoms;

$R^{19}$ is hydrogen, cyano, a substituted or unsubstituted alkyl group of from 1 to 10 carbon atoms, or a substituted or unsubstituted aryl group of from 6 to 10 carbon atoms; and

$R^{20}$ is hydrogen or $R^{18}$.

2. The element of Claim 1 characterized in that $R^4$, $R^6$ and $R^7$ in formula I are cyano, $R^1$ is $C_2H_5$, $C_2H_4OH$, or n-$C_3H_7$ and $R^2$ is $C_2H_5$ or n-$C_3H_7$.

3. The element of Claim 1 characterized in that $R^3$ in formula I is hydrogen, $OC_2H_5$, $CH_3$ or $NHCOCH_3$ and $R^5$ is p-C6H4Cl, m-C6H4NO2 or naphthyl.

4. The element of Claim 1 characterized in that $R^{11}$ is phenyl, $R^{12}$ is ethoxy or $NHR^{13}$, wherein $R^{13}$ is methyl or phenyl, n is 1 and $R^{10}$ is hydrogen.

5. The element of Claim 1 characterized in that $R^{12}$ is O and completes a 6-membered ring fused to the benzene ring, or $R^{12}$ is $NR^{13}R^{14}$, wherein each $R^{13}$ and $R^{14}$ is methyl or $R^{13}$ is ethyl and $R^{14}$ is phenyl.

6. The element of Claim 1 characterized in that $R^{12}$ is $NR^{13}R^{14}$, wherein $R^{13}$ and $R^{14}$ are joined together to form, along with the nitrogen to which they are attached, a pyrrolidine or morpholine ring.

7. The element of Claim 1 characterized in that $R^{15}$ and $R^{16}$ are each ethyl, X is $OCH_3$, J is CO, $R^{17}$ and $R^{18}$ are each $CH_3$, and $R^{19}$ is $C_4H_9$-t.

8. The element of Claim 1 characterized in that $R^{15}$ and $R^{16}$ are each ethyl, X is $OCH_3$, J is CO, $R^{17}$ is $CH_3$, $R^{18}$ is $CH_2CHOHCH_3$, and $R^{19}$ is $C_4H_9$-t.

9. A process of forming a dye transfer image comprising imagewise-heating the black dye-donor element of claim 1 and transferring a dye image to a dye-receiving element to form said dye transfer image.

10. A thermal dye transfer assemblage comprising:
a) the black dye-donor element of claim 1, and
b) a dye-receiving element comprising a support having thereon a dye image-receiving layer, said dye-receiving element being in a superposed relationship with said black dye-donor element so that said dye layer is in contact with said dye image-receiving layer.

**Patentansprüche**

1. Schwarzes Donorelement für die thermische Farbstoffübertragung mit einem Träger, auf dem sich eine Farbstoffschicht befindet, mit einer Mischung aus mindestens einem blaugrünen, purpurroten und gelben Farbstoff, dispergiert in einem polymeren Bindemittel, dadurch gekennzeichnet, daß mindestens einer der blaugrünen Farbstoffe der folgenden Formel entspricht:

I 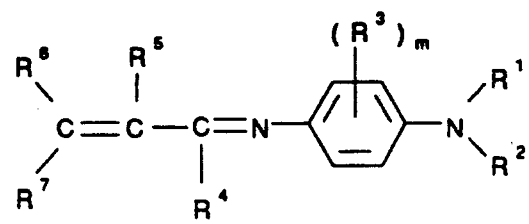

worin bedeuten:
$R^1$ und $R^2$ jeweils unabhängig voneinander Wasserstoff; eine substituierte oder unsubstituierte Alkylgruppe mit 1 bis 10 Kohlenstoffatomen; eine substituierte oder unsubstituierte Cycloalkylgruppe mit 5 bis 7 Kohlenstoffatomen oder eine substituierte oder unsubstituierte Allylgruppe; wobei gilt, daß $R^1$ und $R^2$ nicht beide für Wasserstoff stehen können;
oder $R^1$ und $R^2$ sind miteinander verbunden unter Bildung gemeinsam mit dem Stickstoff, an dem sie sitzen, eines 5- bis 7-gliedrigen heterocyclischen Ringes;
oder einer oder beide der Reste $R^1$ und $R^2$ können mit $R^3$ verbunden sein, unter Bildung eines 5- bis 7-gliedrigen heterocyclischen Ringes;
$R^3$ jeweils unabhängig voneinander Wasserstoff, substituiertes oder unsubstituiertes Alkyl, Cycloalkyl oder Allyl, wie oben für $R^1$ und $R^2$ beschrieben, Alkoxy, Aryloxy, Halogen, Thiocyano, Acylamino, Ureido, Alkylsulfonamido, Arylsulfonamido, Alkylthio, Arylthio oder Trifluoromethyl;

oder beliebige zwei Reste $R^3$ bilden gemeinsam einen 5- oder 6-gliedrigen carbocyclischen oder heterocyclischen Ring;
oder einer oder zwei der Reste $R^3$ können mit entweder einem oder beiden der Reste $R^1$ und $R^2$ kombiniert sein, unter Vervollständigung eines 5- bis 7-gliedrigen Ringes;
m ist eine ganze Zahl von 0 oder 1 bis 4;
$R^4$ steht für Wasserstoff oder eine elektronenabziehende Gruppe;
$R^5$ steht für eine elektronenabziehende Gruppe, eine substituierte oder unsubstituierte Arylgruppe mit 6 bis 10 Kohlenstoffatomen; eine substituierte oder unsubstituierte Hetarylgruppe mit 5 bis 10 Atomen;
$R^6$ und $R^7$ stehen jeweils unabhängig voneinander für eine elektronenabziehende Gruppe; und
$R^6$ und $R^7$ können miteinander kombiniert sein unter Bildung des Restes einer aktiven Methylenverbindung;
oder $R^1$ und $R^2$ stehen jeweils für $-C_2H_5$, $R^3$ steht für $-CH_3$ und $R^5$ ist eine 1-Dibenzofuranylgruppe;
und mindestens einer der gelben Farbstoffe entspricht der Formel:

II 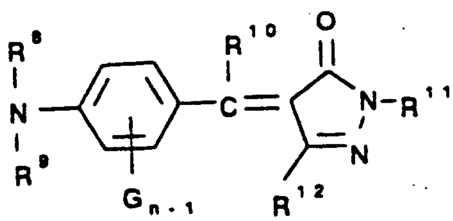

worin bedeuten:
$R^8$, $R^9$ und $R^{11}$ jeweils unabhängig voneinander eine substituierte oder unsubstituierte Alkylgruppe mit 1 bis 10 Kohlenstoffatomen; eine Cycloalkylgruppe von 5 bis 7 Kohlenstoffatomen; eine substituierte oder unsubstituierte Allylgruppe; oder eine substituierte oder unsubstituierte Arylgruppe mit 6 bis 10 Kohlenstoffatomen;
oder $R^8$ und $R^9$ können miteineinander verbunden sein unter Bildung gemeinsam mit dem Stickstoffatom, an dem sie sitzen, eines 5- oder 6-gliedrigen heterocyclischen Ringes;
oder entweder einer oder beide der Reste $R^8$ und $R^9$ können an das Kohlenstoffatom des Benzolringes in einer Stellung ortho zur Stellung der Bindung des Anilinostickstoffatomes gebunden sein, unter Bildung eines 5- oder 6-gliedrigen Ringes unter Bildung eines polycyclischen Systems;
$R^{10}$ steht für Wasserstoff; eine substituierte oder unsubstituierte Alkylgruppe mit 1 bis 10 Kohlenstoffatomen; eine Cycloalkylgruppe mit 5 bis 7 Kohlenstoffatomen; eine substituierte oder unsubstituierte Allylgruppe; Carbamoyl; oder Alkoxycarbonyl;
$R^{12}$ steht für eine substituierte oder unsubstituierte Alkoxygruppe mit 1 bis 10 Kohlenstoffatomen; eine substituierte oder unsubstituierte Aryloxygruppe mit 6 bis 10 Kohlenstoffatomen; $-NHR^{13}$; $-NR^{13}R^{14}$ oder die Atome, die zur Vervollständigung eines 6-gliedrigen Ringes erforderlich sind, der an den Benzolring ankondensiert ist;
$R^{13}$ und $R^{14}$ stehen jeweils unabhängig voneinander für eine der für $R^8$ angegebenen Gruppen; oder
$R^{13}$ und $R1^4$ können miteinander verbunden sein unter Bildung gemeinsam mit dem Stickstoffatom, an dem sie sitzen, eines 5- oder 6-gliedrigen heterocyclischen Ringes;
n ist eine positive Zahl von 2 bis 5; und
G steht für Wasserstoff, eine substituierte oder unsubstituierte Alkyl- oder Alkoxygruppe mit 1 bis 10 Kohlenstoffatomen; Halogen; Aryloxy; oder für die Atome, die zur Vervollständigung eines 5- oder 6-gliedrigen Ringes erforderlich sind, unter Bildung eines kondensierten Ringsystems;
und mindestens einer der purpurroten Farbstoffe entspricht der Formel:

III 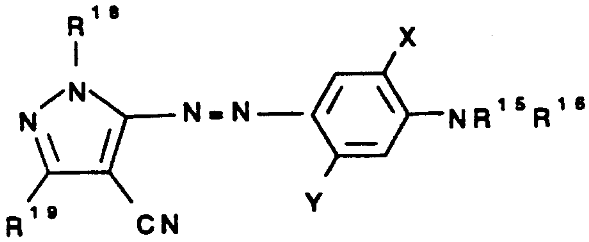

worin bedeuten:
$R^{15}$ eine substituierte oder unsubstituierte Alkyl- oder Allylgruppe mit 1 bis 10 Kohlenstoffatomen;
X eine Alkoxygruppe mit 1 bis 4 Kohlenstoffatomen oder die Atome, die gemeinsam mit $R^{16}$ einen substituierten oder unsubstituierten 5- oder 6-gliedrigen Ring bilden;
$R^{16}$ eine der für $R^{15}$ angegebenen Gruppen oder die Atome, die gemeinsam mit X einen substituierten oder unsubstituierten 5- oder 6-gliedrigen Ring bilden;
Y gleich $R^{15}$, eine Alkoxygruppe mit 1 bis 4 Kohlenstoffatomen, Wasserstoff, Halogen oder $-NHJR^{17}$;
$R^{17}$ eine substituierte oder unsubstituierte Alkylgruppe mit 1 bis 10 Kohlenstoffatomen oder eine substituierte oder unsubstituierte Arylgruppe mit 6 bis 10 Kohlenstoffatomen;
J gleich -CO-, $-CO_2-$, $SO_2$ oder $-CONR^{20}-$;
$R^{18}$ eine substituierte oder unsubstituierte Alkyl- oder Allylgruppe mit 1 bis 10 Kohlenstoffatomen oder eine substituierte oder unsubstituierte Arylgruppe mit 6 bis 10 Kohlenstoffatomen;
$R^{19}$ Wasserstoff, Cyano, eine substituierte oder unsubstituierte Alkylgruppe mit 1 bis 10 Kohlenstoffatomen oder eine substituierte oder unsubstituierte Arylgruppe mit 6 bis 10 Kohlenstoffatomen; und
$R^{20}$ Wasserstoff oder $R^{18}$.

**2.** Element nach Anspruch 1, dadurch gekennzeichnet, daß $R^4$, $R^6$ und $R^7$ in Formel I stehen für Cyano, $R^1$ steht für $C_2H_5$, $-C_2H_4OH$ oder $-n-C_3H_7$ und $R^2$ ist $-C_2H_5$ oder $-n-C_3H_7$.

**3.** Element nach Anspruch 1, dadurch gekennzeichnet, daß $R^3$ in Formel I steht für Wasserstoff, $-OC_2H_5$, $-CH_3$ oder $-NHCOCH_3$ und $R^5$ steht für $-p-C_6H_4Cl$, $-m-C_6H_4NO_2$ oder Naphthyl.

**4.** Element nach Anspruch 1, dadurch gekennzeichnet, daß $R^{11}$ Phenyl ist, $R^{12}$ Ethoxy oder $-NHR^{13}$ ist, wobei $R^{13}$ steht für Methyl oder Phenyl, n ist gleich 1 und $R^{10}$ steht für Wasserstoff.

**5.** Element nach Anspruch 1, dadurch gekennzeichnet, daß $R^2$ gleich O ist und einen 6-gliedrigen Ring, der an den Benzolring ankondensiert ist, vervollständigt, oder $R^{12}$ ist $-NR^{13}R^{14}$, worin jeweils $R^{13}$ und $R^{14}$ für Methyl stehen oder $R^{13}$ ist Ethyl und $R^{14}$ ist Phenyl.

**6.** Element nach Anspruch 1, dadurch gekennzeichnet, daß $R^{12}$ ist $-NR^{13}R^{14}$, worin $R^{13}$ und $^{R1}4$ gemeinsam miteinander verbunden sind, um mit dem Stickstoff, an dem sie sitzen, einen Pyrrolidin- oder Morpholinring zu bilden.

**7.** Element nach Anspruch 1, dadurch gekennzeichnet, daß $R^{15}$ und $R1^6$ jeweils stehen für Ethyl, X ist $-OCH_3$, J ist -CO-, $R^{17}$ und $R^{18}$ stehen jeweils für $CH_3$ und $R^{19}$ steht für $C_4H_9$-t.

**8.** Element nach Anspruch 1, dadurch gekennzeichnet, daß $R^{15}$ und $R^{16}$ jeweils stehen für Ethyl, X steht für $-OCH_3$, J steht für -CO-, $R^{17}$ steht für $-CH_3$, $R^{18}$ ist $-CH_2CHOHCH_3$ und $R^{19}$ steht für $-C_4H_9$-t.

**9.** Verfahren zur Herstellung eines Farbstoffübertragungsbildes, bei dem das schwarze Donorelement des Anspruches 1 bildweise erhitzt wird, und Übertragung eines Farbstoffbildes auf ein Farbstoff-Empfangselement unter Erzeugung des Farbstoffübertragungsbildes.

**10.** Zusammenstellung für die thermische Farbstoffübertragung mit:
a) einem schwarzen Donorelement nach Anspruch 1 und
b) einem Farbstoff-Empfangselement mit einem Träger, auf dem sich eine Farbbild-Empfangsschicht befindet, wobei sich das Farbstoff-Empfangselement in übergeordneter Position zu dem schwarzen Donorelement befindet, derart, daß die Farbstoffschicht in Kontakt mit der Farbbild-Empfangsschicht gelangt.

## Revendications

**1.** Elément donneur de colorant noir pour transfert de colorant par la chaleur comprenant un support recouvert d'une couche de colorant comprenant un mélange d'au moins un colorant cyan, d'un colorant magenta et d'un colorant jaune, dispersés dans un liant polymère caractérisé en ce qu'au moins l'un des colorants cyan a la formule :

I 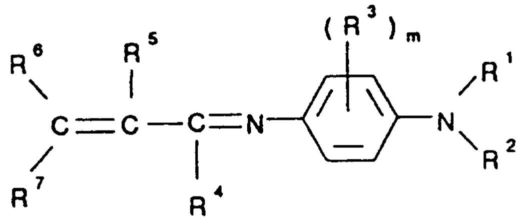

où

$R^1$ et $R^2$ chacun séparément représente l'hydrogène ; un groupe alkyle substitué ou non ayant de 1 à 10 atomes de carbone ; un groupe cycloalkyle substitué ou non ayant de 5 à 7 atomes de carbone ou un groupe allyle substitué ou non ; avec la condition que $R^1$ et $R^2$ ne soient pas tous deux l'hydrogène ;

ou $R^1$ et $R^2$ peuvent ensemble avec l'atome d'azote auxquels ils sont rattachés former un hétérocycle à 5 ou 7 chaînons ;

$R^1$ et/ou $R^2$ peuvent être combinés à $R^3$ pour former un hétérocycle à 5 ou 7 chaînons ;

chaque $R^3$ séparément représente l'hydrogène, un alkyle substitué ou non, un cycloalkyle ou allyle tel que décrit pour $R^1$ et $R^2$ ci-dessus, alkoxy, aryloxy, halogène, thiocyano, acylamino, uréido, alkysulfonamido, arylsulfonamido, alkylthio, arylthio ou trifluorométhyle ;

ou deux $R^3$ quelconques peuvent se combiner ensemble pour former un carbocycle ou un hétérocycle à 5 ou 6 chaînons ;

ou 1 ou 2 $R^3$ peuvent se combiner à $R^1$ et/ou $R^2$ pour compléter un cycle à 5 à 7 chaînons ;

m est un entier de 1 à 4 ;

$R^4$ représente l'hydrogène ou un groupe accepteur d'électrons ;

$R^5$ représente un groupe accepteur d'électrons, un groupe aryle substitué ou non de 6 à 10 atomes de carbone ; un groupe hétéroaryle substitué ou non de 5 à 10 atomes ;

$R^6$ et $R^7$ chacun séparément représentent un groupe accepteur d'électrons ; et

$R^6$ et $R^7$ peuvent se combiner pour former le résidu d'un groupe méthylène actif, ou $R^1$ et $R^2$ sont $C_2H_5$, $R^3$ est $CH_3$ et $R^5$ est un groupe 1-dibenzofuranyle.

et au moins l'un des colorants jaunes a la formule :

I I 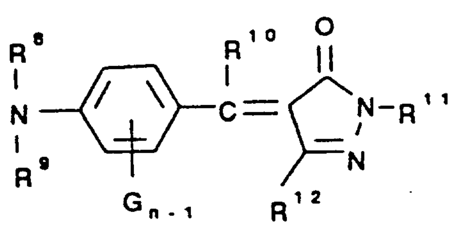

où

$R^8$, $R^9$ et $R^{11}$ chacun séparément représente un groupe alkyle substitué ou non de 1 à 10 atomes de carbone ; un groupe cycloalkyle de 5 à 7 atomes des carbone ; un groupe allyle substitué ou non, un groupe aryle substitué ou non de 6 à 10 atomes de carbone ;

ou $R^8$ et $R^9$ ensemble avec l'atome d'azote auxquels ils sont rattachés forment un hétérocycle à 5 ou 6 chaînons ;

ou $R^8$ et/ou $R^9$ peuvent être rattachés à l'atome de carbone du noyau benzénique en position ortho par rapport à la position de rattachement de l'azote anilino pour former un cycle à 5 ou 6 chaînons, formant ainsi un système polycyclique ;

$R^{10}$ représente l'hydrogène ; un groupe alkyle substitué ou non de 1 à 10 atomes de carbone ; un groupe cycloalkyle de 5 à 7 atomes de carbone ; un groupe allyle substitué ou non ; carbamyle ; ou alkoxycarbonyle ;

$R^{12}$ représente un groupe alkoxy substitué ou non de 1 à 10 atomes de carbone ; un groupe aryloxy substitué ou non de 6 à 10 atomes de carbone ; $NHR^{13}$ : $NR^{13}R^{14}$ ou les atomes nécessaires pour compléter un cycle à 6 chaînons condensé avec le noyau benzénique ;

$R^{13}$ et $R^{14}$ chacun séparément représente l'un quelconque des groupes pour $R^8$ ; ou $R^{13}$ et $R^{14}$ ensemble avec l'atome d'azote auxquels ils sont rattachés forment un hétérocycle à 5 ou 6 chaînons ;

n est un entier positif de 2 à 5 ; et

G représente l'hydrogène, un groupe alkyle ou alkoxy de 1 à 10 atomes de carbone ; halogène ; aryloxy ; ou représente les atomes nécessaires pour compléter un cycle à 5 ou 6 chaînons, formant ainsi un système cyclique condensé :

et au moins l'un des colorants magenta a la formule :

III 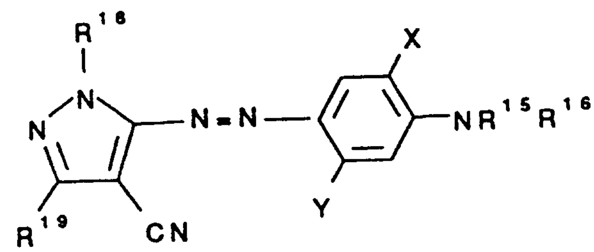

où

$R^{15}$ est un groupe alkyle substitué ou non ou allyle de 1 à 10 atomes de carbone ;

X est un groupe alkoxy de 1 à 4 atomes de carbone ou représente les atomes qui avec $R^{16}$ forment un cycle substitué ou non à 5 ou 6 chaînons ;

$R^{16}$ est l'un des groupes pour $R^{15}$ ou représente les atomes qui ensemble avec X forment un cycle substitué ou non à 5 ou 6 chaînons ;

Y est $R^{15}$, un groupe alkoxy de 1 à 4 atomes de carbone, hydrogène ou $NHJR^{17}$ ;

$R^{17}$ est un groupe alkyle substitué ou non de 1 à 10 atomes de carbone, ou un groupe aryle substitué ou non de 6 à 10 atomes de carbone ;

J est CO, $CO_2$, $-SO_2-$ ou $CONR^{20}-$ ;

$R^{18}$ est un groupe alkyle ou allyle substitué ou non de 1 à 10 atomes de carbone, ou un groupe aryle substitué ou non de 6 à 10 atomes de carbone ;

$R^{19}$ est l'hydrogène, cyano, ou un groupe alkyle substitué ou non de 1 à 10 atomes de carbone, ou un groupe aryle substitué ou non de 6 à 10 atomes de carbone ; et

$R^{20}$ est l'hydrogène ou $R^{18}$.

2. Elément selon la revendication 1, dans lequel $R^4$, $R^6$ et $R^7$ dans la formule I sont cyano, $R^1$ est $C_2H_5$, $C_2H_4OH$, ou n-$C_3H_7$ et $R_2$ est $C_2H_5$ ou n-$C_3H_7$.

3. Elément selon la revendication 1, dans lequel $R^3$ dans la formule I est l'hydrogène, $OC_2H_5$, $CH_3$ ou $NHCOCH_3$ et $R^5$ est p-$C_6H_4Cl$, m-$C_6H_4NO_2$ ou naphtyle.

4. Elément selon la revendication 1, dans lequel $R^{11}$ est phényle, $R^{12}$ est éthoxy ou $NHR^{13}$, où $R^{13}$ est méthyle ou phényle, n est 1 et $R^{10}$ est l'hydrogène.

5. Elément selon la revendication 1, dans lequel $R^{12}$ est O et complète un cycle à 6 chaînons condensé au noyau benzénique, ou $R^{12}$ est $NR^{13}R^{14}$, où chaque $R^{13}$ et $R^{14}$ est méthyle ou $R^{13}$ est éthyle et $R^{14}$ est phényle.

6. Elément selon la revendication 1, dans lequel $R^{12}$ est $NR^{13}R^{14}$, où $R^{13}$ et $R^{14}$ ensemble avec l'atome d'azote auxquels ils sont rattachés forment un cycle pyrrolidine ou morpholine.

7. Elément selon la revendication 1, dans lequel $R^{15}$ est $R^{16}$ sont chacun éthyle, X est $OCH_3$, J est CO, $R^{17}$ est $R^{18}$ sont chacun $CH_3$ et $R^{19}$ est $C_4H_9$-t.

8. Elément selon la revendication 1, dans lequel $R^{15}$ est $R^{16}$ sont chacun éthyle, X est $OCH_3$, J est CO, $R^{17}$ est $CH_3$, $R^{18}$ est $CH_2CHOHCH_3$ et $R^{19}$ est $C_4H_9$-t.

9. Procédé pour former une image par tranfert de colorant, dans lequel on chauffe en conformité avec l'image l'élément donneur de colorant noir de la revendication 1 et on transfère l'image de colorant sur un élément récepteur de colorant pour former l'image par transfert de colorant.

**10.** Assemblage pour transfert de colorant par la chaleur comprenant

a) l'élément donneur de colorant noir de la revendication 1, et

b) un élément récepteur de colorant comprenant un support recouvert d'une couche réceptrice d' image de colorant, l'élément récepteur de colorant et l'élément donneur de colorant étant superposés de sorte que la couche de colorant noir est en contact avec la couche réceptrice d'image de colorant.